# EUROPEAN PATENT APPLICATION

(11) **EP 4 841 862 A1**
(43) Date of publication of application: **18.11.2026**
(21) Application number: 26178703.0
(22) Date of filing: 13.05.2026
(51) Int. Cl.: H02J 13/12, G01R 19/25, G01R 21/133, H02J 3/0012

(54) **CONTROL METHOD, AND APPARATUS FOR POWER SUPPLY SYSTEM AND POWER SUPPLY SYSTEM**

(30) Priority: 13.05.2025 CN 202510619834
(71) Applicant: Shanghai Sigeyuan Intelligent Technology Co., Ltd, Shanghai 201306 (CN)
(72) Inventor: GAO, Liang, 201306 Shanghai (CN); WANG, Kangyu, 201306 Shanghai (CN); QIN, Yijin, 201306 Shanghai (CN)
(74) Representative: DREISS Patentanwälte PartG mbB

(57) **Abstract**

Provided are a control method, and apparatus for a power supply system, and a power supply system, which belong to the field of power supply technologies. The power supply system comprises a power supply device connected to a grid connection point and a power metering device disposed at the grid connection point. The method includes: in response to phase matching of wiring between the grid connection point and voltage sampling lines of respective phases of the power metering device, controlling respective phases of the power supply device to output power, and obtaining current sampled power values of the respective phases of the power metering device; determining, based on the current sampled power values and power values output by the respective phases of the power supply device, a phase matching condition of wiring between the grid connection point and current sampling lines of the respective phases of the power metering device; and in response to a phase sequence misconnection between the grid connection point and the current sampling lines, adjusting sampled output information of the power metering device based on the phase matching condition of the wiring between the grid connection point and the current sampling lines of the respective phases of the power metering device. Correct power data can be obtained without requiring to manually change a wiring harness during a phase sequence misconnection between a grid connection point and current sampling lines.

## Description

### FIELD

The present disclosure relates to the field of power supply technologies, and more particularly, to a control method and apparatus for a power supply system, and a power supply system.

### BACKGROUND

When the photovoltaic storage system performs power control on the grid connection point, the power metering device is required to sample the voltage and current at the grid connection point and perform power calculation. Incorrect wiring of the current sampling line of the power metering device causes abnormal power values calculated by the power metering device, making it impossible for the photovoltaic storage system to accurately control the power at the grid connection point.

Currently, when a wiring error of the power metering device is detected, the mounting personnel is usually prompted to replace the wiring of the power metering device twice or more times until the wiring is correct. However, the wiring at the grid connection point may be very complex, and even with the corresponding prompts, the mounting personnel may still fail to correctly change the wiring of the power metering device.

### SUMMARY

The present disclosure aims to solve at least one of the technical problems in the related art. Therefore, the present disclosure provides a control method and apparatus for a power supply system, and a power supply system, which can obtain correct power data without requiring manual changing of a wiring harness during a phase sequence misconnection between a grid connection point and current sampling lines.

In a first aspect, the present disclosure provides a control method for a power supply system. The power supply system includes a power supply device connected to a grid connection point and a power metering device disposed at the grid connection point, and the method includes: in response to phase matching of wiring between the grid connection point and voltage sampling lines of respective phases of the power metering device, controlling respective phases of the power supply device to output power, and obtaining current sampled power values of the respective phases of the power metering device; determining, based on the current sampled power values and power values output by the respective phases of the power supply device, a phase matching condition of wiring between the grid connection point and the current sampling lines of the respective phases of the power metering device; and in response to a phase sequence misconnection between the grid connection point and the current sampling lines, adjusting sampled output information of the power metering device based on the phase matching condition of the wiring between the grid connection point and the current sampling lines of the respective phases of the power metering device.

With the control method for the power supply system according to the present disclosure, by controlling the respective phases of the power supply device to output power, the phase matching condition of the wiring between the grid connection point and the current sampling lines of the respective phases of the power metering device can be detected. Based on the phase matching condition, output information of current sampling lines of the respective phases of the power metering device can be automatically adjusted, in such a manner that the power values calculated by the power metering device are correct. During the phase sequence misconnection between the grid connection point and the current sampling lines, correct power data can be obtained without requiring a mounting personnel to manually change a wiring harness.

According to an embodiment of the present disclosure, said determining, based on the current sampled power values and the power values output by the respective phases of the power supply device, the phase matching condition of the wiring between the grid connection point and the current sampling lines of the respective phases of the power metering device includes: determining ratios between the current sampled power values of the respective phases and the power values output by the respective phases of the power supply device as first ratios; and determining the phase matching condition based on magnitudes and signs of the first ratios corresponding to the respective phases.

According to an embodiment of the present disclosure, said determining the phase matching condition based on the magnitudes and signs of the first ratios corresponding to the respective phases includes: for each of the respective phases, in response to a difference between an absolute value of a first ratio among the first ratios that corresponds to the phase and a first predetermined ratio being within a first predetermined difference range, determining that a phase sequence misconnection exists for a current sampling line among the current sampling lines that corresponds to the phase.

According to an embodiment of the present disclosure, said determining the phase matching condition based on the magnitudes and signs of the first ratios corresponding to the respective phases includes: for each of the respective phases, determining that a current sampling line among the current sampling lines that corresponds to the phase is connected in reverse in response to a first ratio among the first ratios that corresponds to the phase being negative and a difference between an absolute value of the first ratio and a second predetermined ratio being within a second predetermined difference range, or in response to the first ratio being positive and the difference between the absolute value of the first ratio and a first predetermined ratio being within a first predetermined difference range.

According to an embodiment of the present disclosure, said determining the phase matching condition based on the magnitudes and signs of the first ratios corresponding to the respective phases includes: for each of the respective phases, in response to a difference between an absolute value of a first ratio among the first ratios that corresponds to the phase and a second predetermined ratio being within a second predetermined difference range and the first ratio being positive, determining that a current sampling line among the current sampling lines that corresponds to the phase is correctly connected.

According to an embodiment of the present disclosure, said adjusting the sampled output information of the power metering device based on the phase matching condition of the wiring between the grid connection point and the current sampling lines of the respective phases of the power metering device includes: in response to a three-phase phase sequence misconnection between the current sampling lines and the grid connection point, controlling sampling data of the current sampling lines of any two phases of the power metering device to be exchanged; in response to the sampling data of the current sampling lines of any two phases of the power metering device being exchanged, controlling the respective phases of the power supply device again to output power, and obtaining new current sampled power values of the respective phases of the power metering device; determining, based on the new current sampled power values and power values output again by the respective phases of the power supply device, a new phase matching condition of the wiring between the grid connection point and the current sampling lines; and determining a first phase and a second phase of the power metering device based on the new phase matching condition, and exchanging sampling data of a current sampling line among the current sampling lines that corresponds to the first phase and sampling data of a current sampling line among the current sampling lines that corresponds to the second phase, wherein the first phase and the second phase are phases with a phase sequence misconnection.

According to an embodiment of the present disclosure, said adjusting the sampled output information of the power metering device based on the phase matching condition of the wiring between the grid connection point and the current sampling lines of the respective phases of the power metering device includes: in response to a two-phase phase sequence misconnection between the current sampling lines and the grid connection point, exchanging sampling data of a current sampling line among the current sampling lines that corresponds to a first phase and sampling data of a current sampling line among the current sampling lines that corresponds to a second phase. The first phase and the second phase are phases with a phase sequence misconnection.

According to an embodiment of the present disclosure, the method further includes, subsequent to said determining the phase matching condition of the wiring between the grid connection point and the current sampling lines of the respective phases of the power metering device: for each of the respective phases, in response to a current sampling line among the current sampling lines that corresponds to the phase being connected in reverse, negating the current sampled power value of the phase.

According to an embodiment of the present disclosure, said controlling the respective phases of the power supply device to output power includes: controlling the respective phases of the power supply device to output power at least twice. Said determining, based on the current sampled power values and the power values output by the respective phases of the power supply device, the phase matching condition of the wiring between the grid connection point and the current sampling lines of the respective phases of the power metering device includes: determining, based on power values output by the respective phases of the power supply device at least twice and at least two corresponding current sampled power values, the phase matching condition of the wiring between the grid connection point and the current sampling lines of the respective phases of the power metering device.

In a second aspect, the present disclosure provides a control apparatus for a power supply system. The power supply system includes a power supply device connected to a grid connection point and a power metering device disposed at the grid connection point, and the apparatus includes: a first processing module configured to control, in response to phase matching of wiring between the grid connection point and voltage sampling lines of respective phases of the power metering device, respective phases of the power supply device to output power, and obtain current sampled power values of the respective phases of the power metering device; a second processing module configured to determine, based on the current sampled power values and power values output by the respective phases of the power supply device, a phase matching condition of wiring between the grid connection point and current sampling lines of the respective phases of the power metering device; and a third processing module configured to adjust, in response to a phase sequence misconnection between the grid connection point and the current sampling lines, sampled output information of the power metering device based on the phase matching condition of the wiring between the grid connection point and the current sampling lines of the respective phases of the power metering device.

With the control apparatus for the power supply system according to the present disclosure, by controlling the respective phases of the power supply device to output power, the phase matching condition of the wiring between the grid connection point and the current sampling lines of the respective phases of the power metering device can be detected. Based on the phase matching condition, output information of current sampling lines of the respective phases of the power metering device can be automatically adjusted, in such a manner that the power values calculated by the power metering device are correct. During the phase sequence misconnection between the grid connection point and the current sampling lines, correct power data can be obtained without requiring a mounting personnel to manually change a wiring harness.

In a third aspect, the present disclosure provides a power supply system. The power supply system includes: a power supply device connected to a grid connection point and a power metering device disposed at the grid connection point; and the control apparatus for the power supply system in the above-described second aspect. The control apparatus is connected to the power supply device and the power metering device.

With the power supply system according to the present disclosure, by controlling the respective phases of the power supply device to output power, the phase matching condition of the wiring between the grid connection point and the current sampling lines of the respective phases of the power metering device can be detected. Based on the phase matching condition, output information of current sampling lines of the respective phases of the power metering device can be automatically adjusted, in such a manner that the power values calculated by the power metering device are correct. During the phase sequence misconnection between the grid connection point and the current sampling lines, correct power data can be obtained without requiring a mounting personnel to manually change a wiring harness.

In a fourth aspect, the present disclosure provides an electronic device. The electronic device includes: a processor; a memory; and a computer program stored on memory and executable by the processor. The processor, when executing the computer program, implements the above-described control method for the power supply system in the first aspect.

In a fifth aspect, the present disclosure provides a non-transitory computer-readable storage medium having a computer program stored thereon. The computer program, when executed by a processor, implements the above-described control method for the power supply system in the first aspect.

In a sixth aspect, the present disclosure provides a computer program product including a computer program. The computer program, when executed by the processor, implements the above-described control method for the power supply system in the first aspect.

Additional aspects and advantages of the present disclosure will be provided in part in the following description, or will become apparent in part from the following description, or can be learned from practicing of the present disclosure.

### BRIEF DESCRIPTION OF THE DRAWINGS

Additional aspects and advantages of the present disclosure will be provided in part in the following description, or will become apparent in part from the following description, or can be learned from practicing of the present disclosure.
FIG. 1 is a first schematic flowchart of a control method for a power supply system according to an embodiment of the present disclosure.
FIG. 2 is a first schematic structural diagram of a power supply system according to an embodiment of the present disclosure.
FIG. 3 is a second schematic flowchart of a control method for a power supply system according to an embodiment of the present disclosure.
FIG. 4 is a second schematic structural diagram of a power supply system according to an embodiment of the present disclosure.
FIG. 5 is a third schematic structural diagram of a power supply system according to an embodiment of the present disclosure.
FIG. 6 is a fourth schematic structural diagram of a power supply system according to an embodiment of the present disclosure.
FIG. 7 is a schematic structural diagram of a control apparatus for a power supply system according to an embodiment of the present disclosure.
FIG. 8 is a schematic structural diagram of an electronic device according to an embodiment of the present disclosure.

Reference numerals of the accompanying drawings:
power supply device 210, power metering device 220, power grid 310.

### DETAILED DESCRIPTION OF THE EMBODIMENTS

Description will be made clearly on the technical solutions in the embodiments of the present disclosure with accompanying drawings. Obviously, the embodiments described below are only a part of the embodiments of the present disclosure, rather than all embodiments of the present disclosure. On a basis of the embodiments of the present disclosure, all other embodiments obtained by those skilled in the art without creative labor shall fall within the protection scope of the present disclosure.

Terms "first", "second" and the like in the specification and claims of the present disclosure are used to distinguish similar objects, rather than to describe a specific sequence or order. It should be understood that data used in this way may be interchanged with each other under appropriate circumstances, such that the embodiments of the present disclosure can be implemented in a sequence other than those illustrated or described in the present disclosure. Further, that objects distinguished by "first", "second", etc., generally belong to one class, and the number of objects is not limited. For example, one or more of the first object can be provided. In addition, "and/or" in the description and claims represents at least one of the correlated objects, and the symbol "/" generally indicates an "or" relationship between the correlated objects preceding and succeeding the symbol.

A control method for a power supply system, a control apparatus for a power supply system, a power supply system, an electronic device, and a readable storage medium according to embodiments of the present disclosure will be described in detail below through specific embodiments and application scenarios with reference to the accompanying drawings.

The embodiments of the present disclosure provide the control method for the power supply system. The power supply system includes a power supply device 210 connected to a grid connection point and a power metering device 220 disposed at the grid connection point.

It should be noted that, the power supply device 210 according to the embodiments of the present disclosure may be an inverter, a photovoltaic storage integrated device, or other devices. The power supply device 210 can output alternating current power to supply a load or a power grid 310.

The power supply system has requirements for input and output power limits at the grid connection point. The power supply system executes a corresponding scheduling strategy based on power at the grid connection point. Therefore, the power metering device 220 is usually mounted at the grid connection point to measure real-time power information between the power supply system and the power grid 310. A point at which the power supply device 210 is connected to the power metering device 220 can be regarded as the grid connection point.

The power metering device 220 may be a device for metering power, such as an electricity meter.

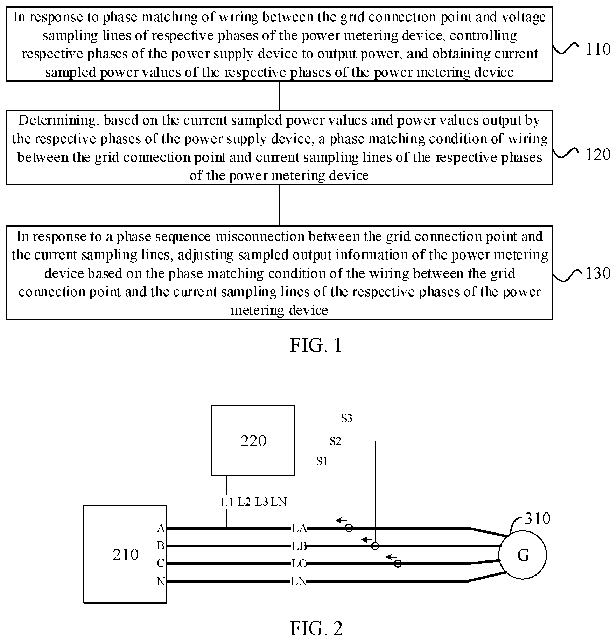

As illustrated in FIG. 2, the power metering device 220 includes four voltage sampling lines (L1, L2, L3, and LN) and three current sampling lines (S1, S2, and S3). Each of the three current sampling lines is connected to a respective current transformer (CT). Alternating current-side output ports (A, B, C, and N) of the power supply device 210 are directly connected to the power grid 310, and these connection lines are denoted as LA, LB, LC, and LN, respectively. A direction in which current flows from the power grid 310 into the power supply device 210 is defined as a positive connection direction of the CT.

For a three-phase grid-connected system, the connected power metering device 220 is provided with three current transformers and three-phase voltage sampling points, which are connected to the power grid 310 via current sampling lines and voltage sampling lines, respectively. Due to complexity of wiring of the electricity meter, a wiring error often occurs, for example, the current sampling lines are not connected to corresponding phase lines of the power grid 310, or the current transformer is connected in reverse.

When the voltage sampling lines and current sampling lines of the power metering device 220, as well as the corresponding CTs, are stably connected to the grid connection point without missing connections, without a plurality of CTs connected to the same line at the grid connection point, and without the CTs connected to LN, the wiring error of the power metering device 220 is reflected in a CT connection position or a CT connection direction. A CT connection position error and a CT connection direction error may occur simultaneously. Table 1 and Table 2 list possible scenarios of the CT connection position and the CT connection direction, respectively.

Abnormal wiring conditions lead to abnormal data measured by the electricity meter, in such a manner that the scheduling strategy of the power supply system is invalidated, which makes it impossible to effectively limit the power at the grid connection point, affecting operational reliability of the power supply system.

**Table 1**

| | Scenario | CT Connection Position Corresponding to S1 | CT Connection Position Corresponding to S2 | CT Connection Position Corresponding to S3 |
|---|---|---|---|---|
| Correct CT Connection Positions | Scenario 1 | LA | LB | LC |
| Two Incorrect CT Connection Positions | Scenario 2 | LB | LA | LC |
| | Scenario 3 | LC | LB | LA |
| | Scenario 4 | LA | LC | LB |
| Three Incorrect CT Connection Positions | Scenario 5 | LC | LA | LB |
| | Scenario 6 | LB | LC | LA |

**Table 2**

| | CT Connection Direction Corresponding to S1 | CT Connection Direction Corresponding to S2 | CT Connection Direction Corresponding to S3 |
|---|---|---|---|
| Scenario 1 | Forward direction | Forward direction | Forward direction |
| Scenario 2 | Reverse direction | Forward direction | Forward direction |
| Scenario 3 | Forward direction | Reverse direction | Forward direction |
| Scenario 4 | Forward direction | Forward direction | Reverse direction |
| Scenario 5 | Reverse direction | Reverse direction | Forward direction |
| Scenario 6 | Reverse direction | Forward direction | Reverse direction |
| Scenario 7 | Forward direction | Reverse direction | Reverse direction |
| Scenario 8 | Reverse direction | Reverse direction | Reverse direction |

It should be noted that, scenarios in Table 1 and Table 2 are independent of each other, and there is no corresponding relationship between the scenarios in Table 1 and Table 2.

For example, scenario 1 in Table 1 can occur simultaneously with any one of scenarios 1 to 8 in Table 2, and scenario 1 in Table 2 can occur simultaneously with any one of scenarios 1 to 6 in Table 1.

In view of a problem of detecting wiring between the current sampling lines of the power metering device 220 and the power grid 310 (i.e., detecting the wiring between the current sampling lines and the grid connection point), the embodiments of the present disclosure provide a control method for a power supply system.

As illustrated in FIG. 1, the control method for the power supply system includes operations at blocks 110, 120, and 130.

At block 110, in response to phase matching of wiring between the grid connection point and voltage sampling lines of respective phases of the power metering device 220, respective phases of the power supply device 210 are controlled to output power, and current sampled power values of the respective phases of the power metering device 220 are obtained.

It should be noted that, the wiring between the voltage sampling lines and the power grid 310 is detected. When the wiring between the voltage sampling lines and the power grid 310 is phase-matched, that is, in the absence of a phase sequence error or an N-line misconnection between the voltage sampling lines and the power grid 310, the wiring between the current sampling lines and the power grid 310 is detected.

In this embodiment, in response to phase matching of the wiring between the voltage sampling lines of the respective phases of the power metering device 220 and the grid connection point, the power supply device 210 is controlled to output power, and present voltage sampling values corresponding to the voltage sampling lines of the respective phases of the power metering device 220 and present current sampling values corresponding to the current sampling lines of the respective phases of the power metering device 220 are obtained.

Based on the present voltage sampling values and the present current sampling values, the current sampled power values of the respective phases of the power metering device 220 is determined, or the present current sampling values are used as the current sampled power values. That is, the current sampled power value may be either a power value or a current value.

It should be noted that, the current sampled power value includes at least one of a current sampled active power value, a current sampled reactive power value, or a current sampled apparent power value.

At block 120, based on the current sampled power values and power values output by the respective phases of the power supply device 210, a phase matching condition of wiring between the grid connection point and current sampling lines of the respective phases of the power metering device 220 is determined.

At this block, based on the current sampled power values of the power supply device 210 collected by the power metering device 220 and the power values output by the power supply device 210, the phase matching condition of the wiring between the grid connection point and the current sampling lines can be determined by comparing the two power values.

It should be understood that, the wiring between the grid connection point and the current sampling lines of the respective phases may be fully matched, and the phase sequence misconnection may occur between the grid connection point and the current sampling lines. The current sampling lines may be connected in a correct direction, or the current sampling lines may also be connected in reverse. The phase matching condition can indicate whether the current sampling lines of the respective phases of the power metering device 220 is connected to the grid connection point of the corresponding phase, and whether the current sampling lines are connected in the correct direction.

In this embodiment, when an internal wiring error occurs in the power supply system, the power supply system is unable to correctly control the power at the grid connection point. The control method for the power supply system according to the embodiments of the present disclosure can detect the wiring error between the grid connection point and the current sampling lines of the respective phases of the power metering device 220 inside the power supply system, and identify the phase matching condition of the wiring between the current sampling lines and the grid connection point based on the respective phases of the grid connection point.

At block 130, in response to a phase sequence misconnection between the grid connection point and the current sampling lines, sampled output information of the power metering device 220 is adjusted based on the phase matching condition of the wiring between the grid connection point and the current sampling lines of the respective phases of the power metering device.

In this embodiment, in response to the phase sequence misconnection between the grid connection point and the current sampling lines, the power values calculated by the power metering device 220 are abnormal. By analyzing the phase matching condition, a misconnection type of the current sampling lines is determined, i.e., whether it is a reverse connection direction or the phase sequence misconnection. When it is the phase sequence misconnection, it is further determined whether it is a three-phase misconnection or a two-phase misconnection. Sampled information of the current sampling lines of the respective phases of the power metering device 220 is adjusted based on the misconnection type of the current sampling lines, in such a manner that the power values calculated by the power metering device 220 are correct, adjusting the sampled output information of the power metering device 220. The sampled output information may be current information and power information output by the power metering device 220.

With the control method for the power supply system according to the embodiments of the present disclosure, by controlling the respective phases of the power supply device 210 to output power, the phase matching condition of the wiring between the grid connection point and the current sampling lines of the respective phases of the power metering device 220 can be detected. Information output by the current sampling lines of the respective phases of the power metering device 220 can be automatically adjusted based on the phase matching condition, in such a manner that the power values calculated by the power metering device 220 are correct. During the phase sequence misconnection between the grid connection point and the current sampling lines, correct power data can be obtained without requiring a mounting personnel to manually change a wiring harness.

In some embodiments, said determining, based on the current sampled power values and the power values output by the respective phases of the power supply device 210, the phase matching condition of the wiring between the grid connection point and the current sampling lines of the respective phases of the power metering device 220 includes: determining ratios between the current sampled power values of the respective phases and the power values output by the respective phases of the power supply device 210 as first ratios; and determining the phase matching condition based on magnitudes and signs of the first ratios corresponding to the respective phases.

The current sampling line of each phase of the power metering device 220 corresponds to a first ratio. For example, a current sampled power value of a current sampling line of phase a is p1, a power value output by phase a of the power supply device 210 is p2, and the first ratio corresponding to the current sampling line of phase a is obtained by dividing p1 by p2.

In this embodiment, for each of the respective phases, whether the phase sequence misconnection exists for a current sampling line among the current sampling lines that corresponds to the phase is determined based on the magnitude of the first ratio corresponding to the phase, and whether the current sampling line is connected in reverse is determined based on the sign of the first ratio corresponding to the phase. The phase matching condition is determined by analyzing the magnitudes and signs of the first ratios of the current sampling lines corresponding to the respective phases.

In some embodiments, said determining the phase matching condition based on the magnitudes and signs of the first ratios corresponding to the respective phases includes: for each of the respective phases, in response to a difference between an absolute value of a first ratio among the first ratios that corresponds to the phase and a first predetermined ratio being within a first predetermined difference range, determining that a phase sequence misconnection exists for a current sampling line among the current sampling lines that corresponds to the phase.

The first predetermined ratio is a preset ratio, which may be 0.5. The first predetermined difference range is a preset difference range, which may be set between -5% and 5% of the first predetermined ratio.

In this embodiment, the absolute value of the first ratio corresponding to the current sampling line is obtained, and the difference between the absolute value of the first ratio and the first predetermined ratio is calculated. If the difference falls within the first predetermined difference range, it indicates that the phase sequence misconnection exists for the current sampling line. That is, the CT connection position is incorrect.

For example, when the first predetermined ratio is 0.5, and the difference between the first ratio and 0.5 is between -5% and 5% of 0.5, it is determined that the corresponding current sampling line is connected to a wrong phase, that is, the phase sequence misconnection exists.

In some embodiments, said determining the phase matching condition based on the magnitudes and signs of the first ratios corresponding to the respective phases includes: for each of the respective phases, determining that a current sampling line among the current sampling lines that corresponds to the phase is connected in reverse in response to a first ratio among the first ratios that corresponds to the phase being negative and a difference between an absolute value of the first ratio and a second predetermined ratio being within a second predetermined difference range, or in response to the first ratio being positive and the difference between the absolute value of the first ratio and a first predetermined ratio being within a first predetermined difference range.

In this embodiment, for the connection direction of the current sampling line, whether the current sampling line is connected in reverse is determined in different ways based on whether a phase sequence connection of the current sampling line is correct.

The difference between the absolute value of the first ratio and the second predetermined ratio within the second predetermined difference range indicates that the phase sequence connection of the current sampling line is correct. When the first ratio is negative because the sign of the sampled power value of this phase of the power metering device 220 is opposite to the sign of the power value output by the power supply device 210, it means that the current sampling line is connected in reverse. Otherwise, the current sampling line is connected in the forward direction.

The difference between the absolute value of the first ratio and the first predetermined ratio within the first predetermined difference range indicates that the phase sequence connection of the current sampling line is incorrect. When the first ratio is positive because the sign of the sampled power value of this phase of the power metering device 220 is the same as the sign of the power value output by the power supply device 210, it means that the current sampling line is connected in reverse. Otherwise, the current sampling line is connected in the forward direction.

In some embodiments, said determining the phase matching condition based on the magnitudes and signs of the first ratios corresponding to the respective phases includes: for each of the respective phases, in response to a difference between an absolute value of a first ratio among the first ratios that corresponds to the phase and a second predetermined ratio being within a second predetermined difference range and the first ratio being positive, determining that a current sampling line among the current sampling lines that corresponds to the phase is correctly connected.

The second predetermined ratio is a preset ratio, which may be 1. The second predetermined difference range is a preset difference range, which may be set between -5% and 5% of the second predetermined ratio.

In this embodiment, the difference between the absolute value of the first ratio and the second predetermined ratio within the second predetermined difference range indicates that the corresponding current sampling line is connected to the correct phase. A positive first ratio indicates that the current sampling line is connected in the correct direction.

For example, when the second predetermined ratio is 1, and the difference between the first ratio and 1 is between -5% and 5% of 1, it is determined that the corresponding current sampling line is connected to the correct phase. In addition, the positive first ratio indicates that the current sampling line is connected in the correct direction and the current sampling line is correctly connected.

When controlling the power supply device 210 to output active power, the influence of load active power is ignored.

When the current sampling line is connected to an incorrect position (phase sequence misconnection), the first ratio between a sampled active power value (current sampled power value) of the corresponding phase of the power metering device 220 and an active power value output by the corresponding phase of the power supply device 210 is 0.5 or -0.5.

When the current sampling line is connected in reverse (correct phase sequence), the first ratio between the sampled active power value of the corresponding phase of the power metering device 220 and the active power value output by the corresponding phase of the power supply device 210 is -1.

**Table 3**

| x | y | z |
|---|---|---|
| ±Qa | ±Qb | ±Qc |
| | ±Qc | ±Qb |
| | ±0.5Qb | ±0.5Qc |
| | ±0.5Qc | ±0.5Qb |
| ±0.5Qa | ±0.5Qb | ±Qc |
| | ±Qc | ±0.5Qb |
| | ±0.5Qc | ±Qb |
| | ±Qb | ±0.5Qc |
| | ±0.5Qb | ±0.5Qc |
| | ±0.5Qc | ±0.5Qb |
| ±Qb | ±Qa | ±Qc |
| | ±Qc | ±Qa |
| | ±0.5Qa | ±0.5Qc |
| | ±0.5Qc | ±0.5Qa |
| ±0.5Qb | ±0.5Qa | ±Qc |
| | ±Qc | ±0.5Qa |
| | ±0.5Qc | ±Qa |
| | ±Qa | ±0.5Qc |
| | ±0.5Qa | ±0.5Qc |
| | ±0.5Qc | ±0.5Qa |
| ±Qc | ±Qb | ±Qa |
| | ±Qa | ±Qb |
| | ±0.5Qb | ±0.5Qa |
| | ±0.5Qa | ±0.5Qb |
| ±0.5Qc | ±0.5Qa | ±Qb |
| | ±Qb | ±0.5Qa |
| | ±0.5Qb | ±Qa |
| | ±Qa | ±0.5Qb |
| | ±0.5Qa | ±0.5Qb |
| | ±0.5Qb | ±0.5Qa |

Similarly, when the power supply device 210 outputs reactive power, the influence of load reactive power is ignored.

When the current sampling line is connected to the incorrect position, the first ratio between a reactive sampled power value (the current sampled power value) of the corresponding phase of the power metering device 220 and the reactive power value output by the corresponding phase of the power supply device 210 is 0.5 or -0.5.

When the current sampling line is connected in reverse, the first ratio between the reactive sampled power value of the corresponding phase of the power metering device 220 and the reactive power value output by the corresponding phase of the power supply device 210 is -1.

The output power of the power supply device 210 is controlled. The output power may be either active power or reactive power, or both active and reactive power simultaneously.

The power supply device 210 is controlled to output power. The output power mode may be simultaneous three-phase power output, or independent sequential output of each phase. For a three-phase three-wire system, the simultaneous three-phase power output is adopted. For a three-phase four-wire system, either the simultaneous three-phase power output or the independent sequential output of each phase can be adopted.

The power supply device 210 is controlled to output power, and a magnitude of the output power for each phase may be the same or different.

Both simultaneous three-phase output and independent three-phase output essentially identify the wiring condition of the power metering device 220 by comparing whether a perturbed power (current) value of the power supply device 210 and the sampled power (current) value of the power metering device 220 satisfy a specific corresponding relationship.

When the output power of the three phases are not equal, (x, y, z) represents that the three-phase power values sampled by the power metering device 220 is x, y, and z, respectively. In this case, the three-phase sampled power values of the power metering device 220 corresponding to different wiring scenarios can be expressed in Table 3.

Since the alternating current-side of the power supply device 210, the voltage sampling of the power metering device 220, and the current sampling of the power metering device 220 can be connected arbitrarily, the three-phase power combinations sampled by the power metering device 220 correspond to the scenarios shown in Table 2 when the three phases of the power supply device 210 output different power. When there is no double relationship between the output power values of the respective phases of the power supply device 210, the above-described power combinations are unique. The current wiring condition can be identified by determining the number of phases in which the power values sampled by the respective phases of the power metering device 220 are identical to the output power values of the respective phases of the power supply device 210.

The power values sampled by the respective phases of the power metering device 220 are compared with the output power values of the three phases of the power supply device 210. When the power value of a certain phase of the power metering device 220 is the same as the absolute value of the output power of the certain phase of the power supply device 210, the current sampling line of this phase of the power metering device 220 is considered to be connected to the correct position. The present wiring condition (phase matching condition) is identified through the number of correctly connected positions of the current sampling lines of the power metering device 220.

Regarding the connection positions of the current sampling lines: ① when the number of current sampling lines that are connected to the correct position is 0, it means that all current sampling lines of the power metering device 220 are connected to the incorrect position; ② when the number of current sampling lines that are connected to the correct position is 1, it means that the current sampling lines of the other two phases of the power metering device 220 are connected to the incorrect position; ③ when the number of current sampling lines that are connected to the correct position is 3, it means that all current sampling lines of the power metering device 220 are connected to the correct position.

Regarding the connection directions of the current sampling lines: the present wiring condition is identified through different power magnitude corresponding relationships based on whether the current sampling lines are connected to the correct position. ① For a phase of the current sampling line that is connected to the correct position, when the sign of the sampled power value of the phase of the power metering device 220 is opposite to the sign of the output power value of the power supply device 210, it means that the current sampling line is connected in reverse, and vice versa for the forward direction. ② For a phase of the current sampling line that is connected to the incorrect position, when the sign of the sampled power value of the power metering device 220 is opposite to the sign of the output power value of the power supply device 210, it means that the current sampling line is connected in the forward direction, and vice versa in reverse.

It should be understood that, a three-phase phase sequence misconnection and a two-phase phase sequence misconnection may exist for the current sampling lines of the power metering device 220. The adjustment of the sampled output information of the power metering device 220 based on the phase matching condition of the wiring between the grid connection point and the current sampling lines of the respective phases under these two types of phase sequence misconnection will be described below.

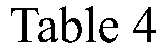

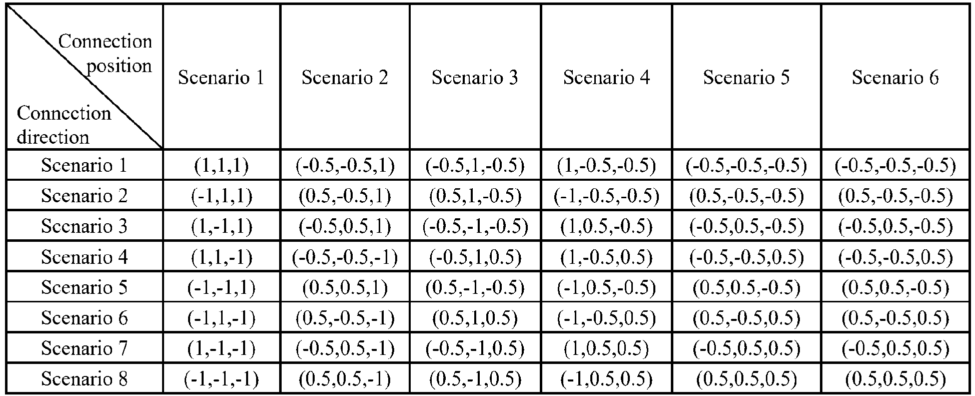

For simplicity of description, taking a mode where the three phases of the power supply device 210 output the same power simultaneously, (x, y, z) represents that the first ratios between the power values of the three phases of the power metering device 220 and the power values output by the three phases of the power supply device 210 are x, y, and z, respectively. The first ratios corresponding to different wiring scenarios can be expressed as shown in Table 4.

In some embodiments, said adjusting the sampled output information of the power metering device 220 based on the phase matching condition of the wiring between the grid connection point and the current sampling lines of the respective phases of the power metering device includes: in response to a three-phase phase sequence misconnection between the current sampling lines and the grid connection point, controlling sampling data of the current sampling lines of any two phases of the power metering device to be exchanged; in response to the sampling data of the current sampling lines of any two phases of the power metering device being exchanged, controlling the respective phases of the power supply device 210 again to output power, and obtaining new current sampled power values of the respective phases of the power metering device 220; determining, based on the new current sampled power values and power values output again by the respective phases of the power supply device 210, a new phase matching condition of the wiring between the grid connection point and the current sampling lines; and determining a first phase and a second phase of the power metering device 220 based on the new phase matching condition, and exchanging sampling data of a current sampling line among the current sampling lines that corresponds to the first phase and sampling data of a current sampling line among the current sampling lines that corresponds to the second phase, wherein the first phase and the second phase are phases with a phase sequence misconnection.

In this embodiment, among all 48 groups of calculation results in Table 4, the three-phase phase sequence misconnection exists between the current sampling line and the grid connection point when the connection positions of the current sampling lines correspond to scenarios 5 and 6 and the connection directions of the current sampling lines correspond to scenarios 1 to 8. It can be seen that the corresponding 16 groups of calculation results are not unique, and the specific wiring form fails to be clearly determined. For such a situation, it is necessary to exchange the sampling data of the current sampling lines once, in such a manner that the connection position of the current sampling line are changed from scenarios 5 and 6 to one of scenarios 1 to 4. A power perturbation is performed again, and the current sampled power values of the respective phases of the power metering device 220 are obtained again. Based on the new current sampled power values and power values output again by the respective phases of the power supply device 210, the new phase matching condition of the wiring between the grid connection point and the current sampling lines is determined. The new phase matching condition is one of scenarios 1 to 4 of the connection positions, that is, a two-phase phase sequence misconnection condition.

Based on the new phase matching condition, two phases with the phase sequence misconnection in the current sampling lines of the power metering device 220 are determined, that is, the first phase and the second phase. The sampling data of the current sampling line of the first phase and the sampling data of the current sampling line of the second phase are exchanged. That is, the current sampling line of the first phase outputs a current value collected by the current sampling line of the second phase, and the current sampling line of the second phase outputs a current value collected by the current sampling line of the first phase. The power is calculated and output based on the exchanged current value, adjusting the sampled output information of the power metering device 220.

In some embodiments, said adjusting the sampled output information of the power metering device 220 based on the phase matching condition of the wiring between the grid connection point and the current sampling lines of the respective phases of the power metering device includes: in response to a two-phase phase sequence misconnection between the current sampling lines and the grid connection point, exchanging sampling data of a current sampling line among the current sampling lines that corresponds to a first phase and sampling data of a current sampling line among the current sampling lines that corresponds to a second phase, wherein the first phase and the second phase are phases with a phase sequence misconnection.

In this embodiment, among all 48 groups of calculation results, the corresponding 32 groups of calculation results are unique when the connection positions of the current sampling lines correspond to scenarios 1 to 4 and the connection directions of the current sampling lines correspond to scenarios 1 to 8. The specific wiring form can be clearly determined through these results. For such a situation, the wiring scenario can be identified by performing only one power perturbation.

Based on the phase matching condition, two phases with the phase sequence misconnection for the current sampling lines of the power metering device 220 are determined, that is, the first phase and the second phase. The sampling data of the current sampling line of the first phase and the sampling data of the current sampling line of the second phase are exchanged. That is, the current sampling line of the first phase outputs the current value collected by the current sampling line of the second phase, and the current sampling line of the second phase outputs the current value collected by the current sampling line of the first phase. The power is calculated and output based on the exchanged current value.

In some embodiments, the method further includes, subsequent to said determining the phase matching condition of the wiring between the grid connection point and the current sampling lines of the respective phases of the power metering device 220: for each of the respective phases, in response to a current sampling line among the current sampling lines that corresponds to the phase being connected in reverse, negating the current sampled power value of the phase.

In this embodiment, when the current sampling line is connected in the incorrect direction, a reading of the power metering device 220 is corrected by negating the current sampled power value of the corresponding phase, to ensure that the reading accurately reflects the actual power flow.

In actual detection, the output power of the power supply device 210 is a sum of alternating current load power and sampled power of the power metering device 220. When the alternating current load is large, the output power of the power supply device 210 differs greatly from the sampled power of the power metering device 220, which can make it impossible to identify the wiring condition of the power metering device 220 through the power combination. Therefore, it is necessary to eliminate the influence of the load power on the detection results. In addition, a sampling error in the power metering device 220 may lead to misidentification of the wiring scenarios. To reduce the error caused by such external factors, a perturbation mode of the power supply device 210 can be further improved.

In some embodiments, said controlling the respective phases of the power supply device 210 to output power includes: controlling the respective phases of the power supply device 210 to output power at least twice. Said determining, based on the current sampled power values and the power values output by the respective phases of the power supply device 210, the phase matching condition of the wiring between the grid connection point and the current sampling lines of the respective phases of the power metering device 220 includes: determining, based on power values output by the respective phases of the power supply device 210 at least twice and at least two corresponding current sampled power values, the phase matching condition of the wiring between the grid connection point and the current sampling lines of the respective phases of the power metering device.

In this embodiment, each power output of the power supply device 210 corresponds to a power value.

The power supply device 210 outputs power at least twice, and by comparing the power values corresponding to each power output, it can be determined whether the obtained power value is reliable. If the power value is reliable, the phase matching condition can be determined based on the power value and the corresponding current sampled power value.

In some embodiments, the respective phases of the power supply device 210 can be controlled to output power twice, and the two power outputs correspond to an output power difference for each phase.

Accordingly, the respective phases of the power metering device 220 sample power twice, two current sampled power values are obtained for each phase. These two current sampled power values correspond to a sampled power difference.

In this embodiment, the phase matching condition can be determined based on magnitude and sign of a ratio between the sampled power difference and the output power difference.

The power supply device 210 can perform two different power perturbations, and a difference between the two power perturbations is used to replace power of a single perturbation, reducing steady-state errors including sampling error and load power. In addition, positive power and negative power can be selected, respectively, during the two power perturbations (power output), and the difference between the two power perturbations is larger than the power value of a single perturbation. Without increasing the magnitude of the power perturbation value, selecting two perturbations can improve the detection accuracy.

Some power metering devices 220 support calibration of the connection position and direction of the current sampling line. The power metering device 220 exposes a calibration interface, receives external commands, and executes corresponding actions to achieve an effect of calibrating the connection position and direction of the current sampling line.

The sampled power values of the power metering device 220 are obtained subsequent to the power supply device 210 performing the power perturbation, and the current wiring scenario is identified by comparing the sampled power values with the output power values of the power supply device 210. The power supply device 210 sends a calibration instruction to the power metering device 220 by calling a calibration interface exposed by the power metering device 220, and the detection process ends subsequent to the power metering device 220 completing the calibration.

A specific embodiment of the control method for the power supply system is described below.

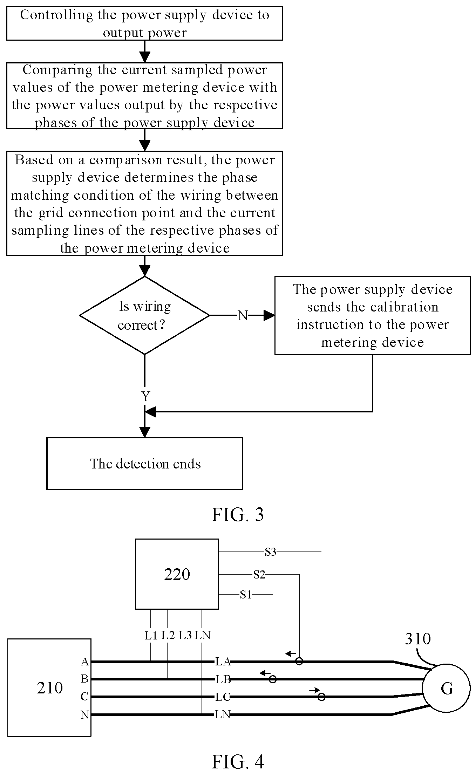

As illustrated in FIG. 3, in step 1, the power supply device 210 is controlled to output power.

In step 2, the current sampled power values of the power metering device 220 and the power values output by the respective phases of the power supply device 210 are compared.

In step 3, based on comparison results, the power supply device 210 determines the phase matching condition of the wiring between the grid connection point and the current sampling lines of the respective phases of the power metering device 220.

In step 4, based on the phase matching condition, the detection ends when the current sampling lines of the respective phases are determined to be correctly connected. Otherwise, the power supply device 210 sends the calibration instruction to the power metering device 220.

Another specific embodiment of the control method for the power supply system is described below.

The phase sequence misconnection exists for two current sampling lines, and the current sampling lines are connected in reverse (with the same output power). As an example, CT1 and CT2 of the power metering device 220 are connected to the incorrect position, and CT3 of the power metering device 220 are connected in reverse, as illustrated in FIG. 4.

CT1 represents a current transformer connected to current sampling line S1, CT2 represents a current transformer connected to current sampling line S2, and CT3 represents a current transformer connected to current sampling line S3.

A control process is as follows:
(1) The three phases of the power supply device 210 are controlled to simultaneously output reactive power Q*_{ref}* of the same magnitude.
(2) The power metering device 220 samples the reactive power values of the three phases, which are Q1, Q2, and Q3, respectively. The reactive power values Qx(x=1,2,3) sampled by the power metering device 220 are calculated from the currents sampled by SX(X=1,2,3) and the voltages sampled by LX.
(3) The magnitude relationship between the reactive power values of the three phases sampled by the power metering device 220 and the reactive power values output by the power supply device 210 is as follows: $\left\{\begin{matrix}{Q}_{1} = - 0.5 {Q}_{ref} \\ {Q}_{2} = - 0.5 {Q}_{ref} \\ {Q}_{3} = - {Q}_{ref}\end{matrix}\right. .$
(4) The wiring configuration of the power metering device 220 can be identified as: CT3 is connected in reverse, and CT1 and CT2 are connected to the incorrect position.
(5) The power supply device 210 identifies the current wiring configuration of the power metering device 220 and sends a CT adjustment instruction to the power metering device 220: exchange the connection positions of CT1 and CT2; and reverse the connection direction of CT3. Subsequent to receiving the adjustment instruction, the power metering device 220 exchanges the sampling data of CT1 and CT2, and negates the sampling data of CT3. The detection is completed.

Another specific embodiment of the control method for the power supply system is described below.

The phase sequence misconnection exists for all current sampling lines of the power metering device 220, and some current sampling lines are connected in reverse (with the same output power).

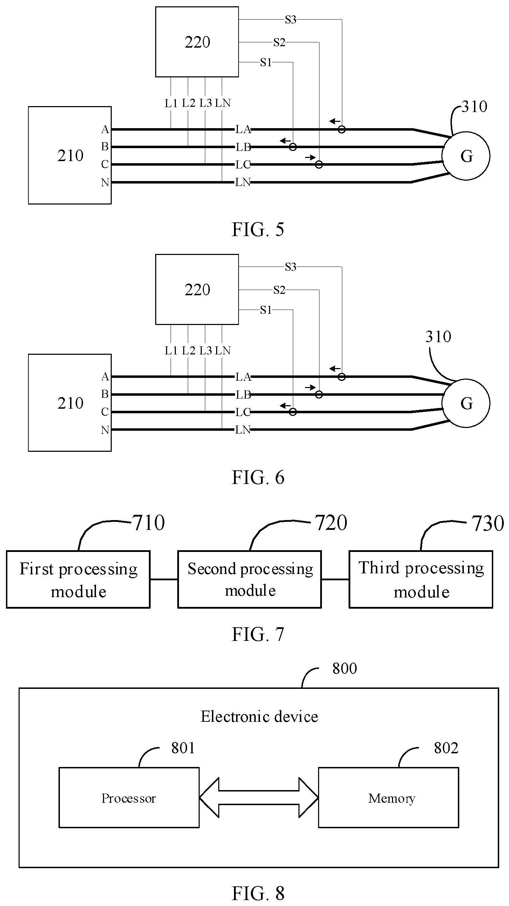

As an example, CT1, CT2, and CT3 of the power metering device 220 are connected to the incorrect position, and CT2 of the power metering device 220 are connected in reverse, as illustrated in FIG. 5.

The control process is as follows:
(1) The three phases of the power supply device 210 are controlled to simultaneously output reactive power Q*_{ref1}* of the same magnitude.
(2) The reactive power values of the three phases sampled by the power metering device 220 are Q₁₋₁, Q₂₋₁, and Q₃₋₁, respectively.
(3) The magnitude relationship between the reactive power values of the three phases sampled by the power metering device 220 and the reactive power values output by the power supply device 210 is as follows: $\left\{\begin{matrix}{Q}_{1 - 1} = - 0.5 {Q}_{ref 1} \\ {Q}_{2 - 1} = - 0.5 {Q}_{ref 1} \\ {Q}_{3 - 1} = - 0.5 {Q}_{ref 1}\end{matrix}\right. .$

The wiring configuration can be identified as follows: CT1, CT2, and CT3 are all connected to the incorrect position. There are two scenarios where CT1, CT2, and CT3 are connected to the incorrect position, making it impossible to accurately identify the specific current wiring scenario.

The power supply device 210 sends the CT adjustment instruction to the power metering device 220, to exchange any two of the three CTs, for example, to exchange CT1 and CT2.

Subsequent to receiving a CT connection position adjustment instruction, the power metering device 220 internally exchanges the sampling data of CT1 and CT2. An equivalent wiring diagram of the power metering device 220 in this case is illustrated in FIG. 6.
(1) The power supply device 210 is controlled to output reactive power Q*_{ref2}* again.
(2) Similarly, the power metering device 220 samples the reactive power values of the three phases, which are Q₁₋₂, Q₂₋₂, and Q₃₋₂, respectively.
(3) The magnitude relationship between the reactive power values of the three phases sampled by the power metering device 220 and the reactive power values output by the power supply device 210 is as follows: $\left\{\begin{matrix}{Q}_{1 - 2} = - 0.5 {Q}_{ref 2} \\ {Q}_{2 - 2} = - {Q}_{ref 2} \\ {Q}_{3 - 2} = - 0.5 {Q}_{ref 2}\end{matrix}\right. .$

The external wiring configuration can be obtained as follows: CT2 is connected in reverse, and CT1 and CT3 are connected to the incorrect position.

The power supply device 210 identifies the current wiring condition of the power metering device 220, and sends the CT adjustment instruction to the power metering device 220: exchange the connection positions of CT1 and CT3, and reverse the connection direction of CT2. Subsequent to receiving the adjustment instruction, the power metering device 220 exchanges the sampling data of CT1 and CT3, and negates the sampling data of CT2. The detection is completed.

Another specific embodiment of the control method for the power supply system is described below.

The phase sequence misconnection exists for all current sampling lines, and the current sampling lines are connected in reverse (with different output power), as illustrated in FIG. 5.

The control process is as follows:
(1) The three phases of the power supply device 210 are controlled to simultaneously output reactive power of different magnitudes: *Q_{refa1}*, *Q_{refb1}*, and *Q_{refc1}.*
(2) The reactive power values of the three phases sampled by the power metering device 220 are Q₁₋₁, Q₂₋₁, and Q₃₋₁, respectively.
(3) The magnitude relationship between the reactive power values of the three phases sampled by the power metering device 220 and the reactive power values output by the power supply device 210 can be expressed as: $\left\{\begin{matrix}{Q}_{1 - 1} = - 0.5 {Q}_{refb 1} \\ {Q}_{2 - 1} = 0.5 {Q}_{refc 1} \\ {Q}_{3 - 1} = - 0.5 {Q}_{refa 1}\end{matrix}\right. .$
   (1) The number of phases with the same power between the power sampled by each phase of the power metering device 220 and the power output by each phase of the power supply device 210 is 0, indicating that the three CTs of the power metering device 220 are connected in the incorrect position.
   (2) The power supply device 210 issues the CT adjustment instruction to the power metering device 220, to exchange any two of the three CTs, for example, to exchange CT1 and CT2.
   (3) The three phases of the power supply device 210 are controlled to simultaneously output reactive power of different magnitudes *Q_{refa2}*, *Q_{refb2}*, and *Q_{refc2}.*
   (4) The power metering device 220 samples the reactive power values of the three phases, which are Q₁₋₂, Q₂₋₂, and Q₃₋₂, respectively.

The magnitude relationship between the reactive power values of the three phases sampled by the power metering device 220 and the reactive power values output by the power supply device 210 is as follows: $\left\{\begin{matrix}{Q}_{1 - 2} = - 0.5 {Q}_{refc 2} \\ {Q}_{2 - 2} = - {Q}_{refb 2} \\ {Q}_{3 - 2} = - 0.5 {Q}_{refa 2}\end{matrix}\right. .$
(5) The external wiring configuration can be obtained as follows: CT2 is connected in reverse, and CT1 and CT3 are connected in the incorrect position.

The power supply device 210 identifies the current wiring condition of the power metering device 220 and sends the CT adjustment instruction to the power metering device 220: exchange the connection positions of CT1 and CT3; and reverse the connection direction of CT2. Subsequent to receiving the adjustment instruction, the power metering device 220 exchanges the sampling data of CT1 and CT3, and negates the sampling data of CT2. The detection is completed.

Another specific embodiment of the control method for the power supply system is described below.

The power supply device 210 performs two perturbations in each detection to improve the detection accuracy.

To reduce the error caused by the external factors, the perturbation process can be further optimized by controlling the photovoltaic storage system to initiate two power perturbations.

The control process is as follows:
(1) The reactive power values output by the three phases of the power supply device 210 for the first time are Q*_{A1}*, Q*_{B1}*, and Q*_{C1}*, respectively.
(2) The reactive power values of the three phases sampled by the power metering device 220 are recorded as Q₁₁, Q₂₁, and Q₃₁, respectively.
(3) The reactive power values output by the three phases of the photovoltaic storage system are controlled to be Q*_{A2}*, Q*_{B2}*, and Q*_{C2}*, respectively.
(4) The reactive power values of the three phases sampled by the power metering device 220 are recorded as Q₁₂, Q₂₂, and Q₃₂, respectively.
(5) The differences between the two power perturbations of the power supply device 210 are ΔQ*_{A}*, ΔQ*_{B}*, and ΔQ*_{C}*, respectively, and the reactive power differences of the three phases sampled by the power metering device 220 are ΔQ1, ΔQ2, and ΔQ3, respectively. Their magnitude relationship can be expressed as: $\left\{\begin{matrix}Δ {Q}_{A} = {Q}_{A 2} - {Q}_{A 1} \\ Δ {Q}_{B} = {Q}_{B 2} - {Q}_{B 1} \\ Δ {Q}_{C} = {Q}_{C 2} - {Q}_{C 1} \\ Δ {Q}_{1} = {Q}_{12} - {Q}_{11} \\ Δ {Q}_{2} = {Q}_{22} - {Q}_{21} \\ Δ {Q}_{3} = {Q}_{32} - {Q}_{31}\end{matrix}\right. .$

(1) By comparing the differences between the two power perturbations, the magnitude relationship between the reactive power differences of the three phases sampled by the power metering device 220 and the reactive power differences output by the photovoltaic storage system can be expressed as: $\left\{\begin{matrix}Δ {Q}_{1} = - 0.5 Δ {Q}_{B} \\ Δ {Q}_{2} = - 0.5 Δ {Q}_{A} \\ Δ {Q}_{3} = - Δ {Q}_{C}\end{matrix}\right. .$

The two perturbations do not change the magnitude relationship between the detection data, and thus do not affect the identification of the wiring scenario.

In the related art, the wiring state of the power metering device 220 is identified through some power perturbations or current variations. When the wiring error occurs, it is necessary to prompt the mounting personnel to replace the wiring of the power metering device 220 twice or more times until the wiring is correct. The power metering device 220 is usually connected at the grid connection point, and on-site wiring may be very complex or messy. Even with the corresponding prompts, the mounting personnel may still fail to correctly change the wiring of the power metering device 220.

The control method for the power supply system according to the embodiments of the present disclosure obtains the current sampled power values of the power metering device 220 at a corresponding moment in the power supply device 210 by means of power perturbation, and determines the current phase matching condition of the power metering device 220 using the current sampled power values. Based on the phase matching condition of the power metering device 220, the power metering device 220 is controlled to exchange the corresponding current sampling data, which achieves correct power control of the grid connection point by the power supply device 210 without requiring the mounting personnel to manually change the wiring harness.

It should be noted that, the power metering device 220 can be controlled manually, or the power supply device 210 can control the power metering device 220 through the interface exposed by the power metering device 220, etc. There are various ways to exchange the sampling data of the power metering device 220, depending on the internal implementation of the manufacturer of the power metering device 220. The implementation includes, but is not limited to, the power metering chip of the power metering device 220 exchanging analog-to-digital (AD) sampling channels. The power metering chip exchanges sampling data by controlling the sampling channel sequence of the external chip select chip.

The execution subject of the control method for the power supply system according to the embodiments of the present disclosure can be a control apparatus for a power supply system. In the embodiments of the present disclosure, the control apparatus for the power supply system executing the control method for the power supply system is taken as an example to describe the control apparatus for the power supply system according to the embodiments of the present disclosure.

The embodiments of the present disclosure further provide a control apparatus for a power supply system.

As illustrated in FIG. 7, the control apparatus for the power supply system includes: a first processing module 710 configured to control, in response to phase matching of wiring between the grid connection point and voltage sampling lines of respective phases of the power metering device 220, respective phases of the power supply device 210 to output power, and obtain current sampled power values of the respective phases of the power metering device 220; a second processing module 720 configured to determine, based on the current sampled power values and power values output by the respective phases of the power supply device, a phase matching condition of wiring between the grid connection point and current sampling lines of the respective phases of the power metering device 220; and a third processing module 730 configured to adjust, in response to a phase sequence misconnection between the grid connection point and the current sampling lines, sampled output information of the power metering device based on the phase matching condition of the wiring between the grid connection point and the current sampling lines of the respective phases of the power metering device 220.

With the control apparatus for the power supply system according to the present disclosure, by controlling the respective phases of the power supply device 210 to output power, the phase matching condition of the wiring between the grid connection point and the current sampling lines of the respective phases of the power metering device 220 can be detected. Based on the phase matching condition, the output information of the current sampling lines of the respective phases of the power metering device 220 can be automatically adjusted, in such a manner that the power values calculated by the power metering device 220 are correct. During the phase sequence misconnection between the grid connection point and the current sampling lines, correct power data can be obtained without requiring the mounting personnel to manually change the wiring harness.

In some embodiments, the second processing module 720 is configured to determine ratios between the current sampled power values of the respective phases and the power values output by the respective phases of the power supply device 210 as first ratios; and determine the phase matching condition based on magnitudes and signs of the first ratios corresponding to the respective phases.

In some embodiments, the second processing module 720 is configured to determine that a phase sequence misconnection exists for a current sampling line among the current sampling lines that corresponds to the phase, for each of the respective phases and in response to a difference between an absolute value of a first ratio among the first ratios that corresponds to the phase and a first predetermined ratio being within a first predetermined difference range.

In some embodiments, the second processing module 720 is configured to determine that a current sampling line among the current sampling lines that corresponds to the phase is connected in reverse, in response to a first ratio among the first ratios that corresponds to the phase being negative and a difference between an absolute value of the first ratio and a second predetermined ratio being within a second predetermined difference range, or in response to the first ratio being positive and the difference between the absolute value of the first ratio and a first predetermined ratio being within a first predetermined difference range, for each of the respective phases.

In some embodiments, the second processing module 720 is configured to determine that a current sampling line among the current sampling lines that corresponds to the phase is correctly connected, for each of the respective phases and in response to a difference between an absolute value of a first ratio among the first ratios that corresponds to the phase and a second predetermined ratio being within a second predetermined difference range and the first ratio being positive.

In some embodiments, the third processing module 730 is configured to sampling data of the current sampling lines of any two phases of the power metering device to be exchanged in response to a three-phase phase sequence misconnection between the current sampling lines and the grid connection point; control the respective phases of the power supply device again to output power, and obtain new current sampled power values of the respective phases of the power metering device in response to the sampling data of the current sampling lines of any two phases of the power metering device being exchanged; determine, based on the new current sampled power values and power values output again by the respective phases of the power supply device, a new phase matching condition of the wiring between the grid connection point and the current sampling lines; and determine a first phase and a second phase of the power metering device based on the new phase matching condition, and exchanging sampling data of a current sampling line among the current sampling lines that corresponds to the first phase and sampling data of a current sampling line among the current sampling lines that corresponds to the second phase, wherein the first phase and the second phase are phases with a phase sequence misconnection.

In some embodiments, the third processing module 730 is configured to exchange sampling data of a current sampling line among the current sampling lines that corresponds to a first phase and sampling data of a current sampling line among the current sampling lines that corresponds to a second phase in response to a two-phase phase sequence misconnection between the current sampling lines and the grid connection point. The first phase and the second phase are phases with a phase sequence misconnection.

In some embodiments, the third processing module 730 is configured to negate the current sampled power value of the phase, for each of the respective phases and in response to a current sampling line among the current sampling lines that corresponds to the phase being connected in reverse.

In some embodiments, the first processing module 710 is configured to control the respective phases of the power supply device 210 to output power at least twice. Said determining, based on the current sampled power values and the power values output by the respective phases of the power supply device 210, the phase matching condition of the wiring between the grid connection point and the current sampling lines of the respective phases of the power metering device 220 includes: determining, based on power values output by the respective phases of the power supply device 210 at least twice and at least two corresponding current sampled power values, the phase matching condition of the wiring between the grid connection point and the current sampling lines of the respective phases of the power metering device 220.

The control apparatus for the power supply system in the embodiments of the present disclosure can be an electronic device, or a component in the electronic device, such as an integrated circuit or a chip. The electronic device can be a terminal, or may be other devices other than a terminal.

The control apparatus for the power supply system according to the embodiments of the present disclosure can be a device having an operating system. The operating system can be an Android operating system, an IOS operating system, or other possible operating systems, which are not specifically limited in the embodiments of the present disclosure.

The control apparatus for the power supply system according to the embodiments of the present disclosure can implement each process of the method embodiments of FIG. 1 and FIG. 3, and thus details thereof will be omitted herein to avoid repetition.

The embodiments of the present disclosure further provide a power supply system.

As illustrated in FIG. 2, the power supply system includes a power supply device 210 connected to a grid connection point and a power metering device 220 disposed at the grid connection point.

The power supply system further includes the above-described control apparatus for the power supply system. The control apparatus is connected to the power supply device 210 and the power metering device 220.

With the power supply system according to the embodiments of the present disclosure, by controlling the respective phases of the power supply device 210 to output power, the phase matching condition of the wiring between the grid connection point and the current sampling lines of the respective phases of the power metering device 220 can be detected. Based on the phase matching condition, the output information of the current sampling lines of the respective phases of the power metering device 220 can be automatically adjusted, in such a manner that the power values calculated by the power metering device 220 are correct. During the phase sequence misconnection between the grid connection point and the current sampling lines, the correct power data can be obtained without requiring the mounting personnel to manually change the wiring harness.

In some embodiments, as illustrated in FIG. 8, the embodiments of the present disclosure further provide an electronic device 800 including a processor 801, a memory 802, and a computer program stored in the memory 802 and executable on the processor 801. The program, when executed by the processor 801, implements the above-described control method embodiments for the power supply system, and the same technical effect can be achieved. Details thereof will not be omitted here to avoid repetition.

It should be noted that, the electronic device according to the embodiments of the present disclosure include the mobile electronic device and the non-mobile electronic device described above.

The embodiments of the present disclosure further provide a non-transitory computer-readable storage medium having a computer program stored thereon. The computer program, when executed by a processor, implements the control method embodiments for the power supply system described above, and can achieve the same technical effects. Details thereof will not be omitted here to avoid repetition.

The processor is a processor in the electronic device described in the above embodiments. The readable storage medium includes a computer-readable storage medium such as a computer read-only memory (ROM), a random access memory (RAM), a magnetic disk, or an optical disk.

The embodiments of the present disclosure further provide a computer program product including a computer program. The computer program, when executed by a processor, implements the control method for the power supply system described above.

The processor is a processor in the electronic device described in the above embodiments. The readable storage medium includes a computer-readable storage medium such as a computer read-only memory (ROM), a random access memory (RAM), a magnetic disk, or an optical disk.

The embodiments of the present disclosure further provide a chip including a processor and a communication interface coupled to the processor. The processor is configured to run a program or an instruction to implement the control method embodiments for the power supply system, and can achieve the same technical effect. Details thereof will not be omitted here to avoid repetition.

It should be understood that, the chip mentioned in the embodiments of the present disclosure can also be referred to as a system-level chip, a system-chip, a chip system, or a system-on-chip.

Further, in the present disclosure, it should be noted that terms "comprise", "include" or any other variations thereof are meant to cover non-exclusive including, such that the process, method, goods or device including a series of elements do not only include those elements, but further include other elements that are not explicitly listed, or further include inherent elements of the process, method, goods or device. In a case that there are no more restrictions, an element limited with the statement "comprises a ..." does not exclude the presence of additional identical elements in the process, method, goods or device that includes the said element. In addition, it should be noted that the scope of the methods and devices in the embodiments of the present disclosure is not limited to performing functions in the order shown or discussed, and can also include performing functions in a substantially simultaneous manner or in the reverse order according to the functions involved. For example, the described methods can be performed in an order different from that described, and various steps can be added, omitted, or combined. In addition, features described with reference to certain examples can be combined in other examples.

From the above description of the implementations, it will be clear to those skilled in the art that the method in the above embodiments can be implemented with the aid of software and a necessary common hardware platform or can be implemented through hardware. In many cases, the former one is a better implementation. Based on this understanding, all of the technical solutions according to the embodiments of the present disclosure, or the part thereof that contributes to the related art, can be embodied in the form of a computer software product. The computer software product can be stored in a storage medium (such as a ROM/RAM, a disk, and an optical disk) and contain instructions to enable a terminal device (which can be a computer, a server, a network device, etc.) to perform the method described in each of the embodiments of the present disclosure.

The embodiments of the present disclosure are described above with reference to the accompanying drawings, but the present disclosure is not limited to the above specific implementations, which are merely illustrative, rather than restrictive. Under the motivation of the present disclosure, those skilled in the art can also make many variations without departing from the principles of the present disclosure and the protection scope of the claims as attached. These variations are to be encompassed by the protect scope of present disclosure.

Reference throughout this specification to "an embodiment", "some embodiments", "schematic embodiments", "an example", "a specific example", or "some examples" means that a particular feature, structure, material, or characteristic described in connection with the embodiment or example is included in at least one embodiment or example of the present disclosure. In this specification, exemplary descriptions of aforesaid terms are not necessarily referring to the same embodiment or example. Further, the particular features, structures, materials, or characteristics can be combined in any suitable manner in one or more embodiments or examples.

Although embodiments of the present disclosure have been illustrated and described, it is conceivable for those of ordinary skill in the art that various changes, modifications, replacements, and variations can be made to these embodiments without departing from the principles and spirit of the present disclosure. The scope of the present disclosure shall be defined by the claims as appended and their equivalents.

## Claims

1. A control method for a power supply system, wherein the power supply system comprises a power supply device connected to a grid connection point and a power metering device disposed at the grid connection point, and the method comprises:
in response to phase matching of wiring between the grid connection point and voltage sampling lines of respective phases of the power metering device, controlling respective phases of the power supply device to output power, and obtaining current sampled power values of the respective phases of the power metering device;
determining, based on the current sampled power values and power values output by the respective phases of the power supply device, a phase matching condition of wiring between the grid connection point and current sampling lines of the respective phases of the power metering device; and
in response to a phase sequence misconnection between the grid connection point and the current sampling lines, adjusting sampled output information of the power metering device based on the phase matching condition of the wiring between the grid connection point and the current sampling lines of the respective phases of the power metering device.

2. The control method for the power supply system according to claim 1, wherein said determining, based on the current sampled power values and the power values output by the respective phases of the power supply device, the phase matching condition of the wiring between the grid connection point and the current sampling lines of the respective phases of the power metering device comprises:
determining ratios between the current sampled power values of the respective phases and the power values output by the respective phases of the power supply device as first ratios; and
determining the phase matching condition based on magnitudes and signs of the first ratios corresponding to the respective phases.

3. The control method for the power supply system according to claim 2, wherein said determining the phase matching condition based on the magnitudes and signs of the first ratios corresponding to the respective phases comprises:
for each of the respective phases, in response to a difference between an absolute value of a first ratio among the first ratios that corresponds to the phase and a first predetermined ratio being within a first predetermined difference range, determining that a phase sequence misconnection exists for a current sampling line among the current sampling lines that corresponds to the phase.

4. The control method for the power supply system according to claim 2, wherein said determining the phase matching condition based on the magnitudes and signs of the first ratios corresponding to the respective phases comprises:
for each of the respective phases, determining that a current sampling line among the current sampling lines that corresponds to the phase is connected in reverse in response to a first ratio among the first ratios that corresponds to the phase being negative and a difference between an absolute value of the first ratio and a second predetermined ratio being within a second predetermined difference range, or in response to the first ratio being positive and the difference between the absolute value of the first ratio and a first predetermined ratio being within a first predetermined difference range.

5. The control method for the power supply system according to claim 2, wherein said determining the phase matching condition based on the magnitudes and signs of the first ratios corresponding to the respective phases comprises:
for each of the respective phases, in response to a difference between an absolute value of a first ratio among the first ratios that corresponds to the phase and a second predetermined ratio being within a second predetermined difference range and the first ratio being positive, determining that a current sampling line among the current sampling lines that corresponds to the phase is correctly connected.

6. The control method for the power supply system according to any one of claims 1 to 5, wherein said adjusting the sampled output information of the power metering device based on the phase matching condition of the wiring between the grid connection point and the current sampling lines of the respective phases of the power metering device comprises:
in response to a three-phase phase sequence misconnection between the current sampling lines and the grid connection point, controlling sampling data of the current sampling lines of any two phases of the power metering device to be exchanged;
in response to the sampling data of the current sampling lines of any two phases of the power metering device being exchanged, controlling the respective phases of the power supply device again to output power, and obtaining new current sampled power values of the respective phases of the power metering device;
determining, based on the new current sampled power values and power values output again by the respective phases of the power supply device, a new phase matching condition of the wiring between the grid connection point and the current sampling lines; and
determining a first phase and a second phase of the power metering device based on the new phase matching condition, and exchanging sampling data of a current sampling line among the current sampling lines that corresponds to the first phase and sampling data of a current sampling line among the current sampling lines that corresponds to the second phase, wherein the first phase and the second phase are phases with a phase sequence misconnection.

7. The control method for the power supply system according to any one of claims 1 to 5, wherein said adjusting the sampled output information of the power metering device based on the phase matching condition of the wiring between the grid connection point and the current sampling lines of the respective phases of the power metering device comprises:
in response to a two-phase phase sequence misconnection between the current sampling lines and the grid connection point, exchanging sampling data of a current sampling line among the current sampling lines that corresponds to a first phase and sampling data of a current sampling line among the current sampling lines that corresponds to a second phase, wherein the first phase and the second phase are phases with a phase sequence misconnection.

8. The control method for the power supply system according to any one of claims 1 to 5, wherein the method further comprises, subsequent to said determining the phase matching condition of the wiring between the grid connection point and the current sampling lines of the respective phases of the power metering device:
for each of the respective phases, in response to a current sampling line among the current sampling lines that corresponds to the phase being connected in reverse, negating the current sampled power value of the phase.

9. The control method for the power supply system according to any one of claims 1 to 5, wherein:
said controlling the respective phases of the power supply device to output power comprises:
controlling the respective phases of the power supply device to output power at least twice, and
said determining, based on the current sampled power values and the power values output by the respective phases of the power supply device, the phase matching condition of the wiring between the grid connection point and the current sampling lines of the respective phases of the power metering device comprises:
determining, based on power values output by the respective phases of the power supply device at least twice and at least two corresponding current sampled power values, the phase matching condition of the wiring between the grid connection point and the current sampling lines of the respective phases of the power metering device.

10. A control apparatus for a power supply system, wherein the power supply system comprises a power supply device connected to a grid connection point and a power metering device disposed at the grid connection point, and the apparatus comprises:
a first processing module configured to control, in response to phase matching of wiring between the grid connection point and voltage sampling lines of respective phases of the power metering device, respective phases of the power supply device to output power, and obtain current sampled power values of the respective phases of the power metering device;
a second processing module configured to determine, based on the current sampled power values and power values output by the respective phases of the power supply device, a phase matching condition of wiring between the grid connection point and current sampling lines of the respective phases of the power metering device; and
a third processing module configured to adjust, in response to a phase sequence misconnection between the grid connection point and the current sampling lines, sampled output information of the power metering device based on the phase matching condition of the wiring between the grid connection point and the current sampling lines of the respective phases of the power metering device.

11. A power supply system, comprising:
a power supply device connected to a grid connection point;
a power metering device disposed at the grid connection point; and
the control apparatus for the power supply system according to claim 10, wherein the control apparatus is connected to the power supply device and the power metering device.
